Europäisches Patentamt

European Patent Office

Office européen des brevets

(11) Publication number: **0 513 376 A1**

# EUROPEAN PATENT APPLICATION
## published in accordance with Art. 158(3) EPC

(21) Application number: **91920693.8**

(22) Date of filing: **29.11.91**

(86) International application number:
**PCT/JP91/01644**

(87) International publication number:
**WO 92/10079 (11.06.92 92/13)**

(51) Int. Cl.⁵: **H05K 3/40**, H05K 3/20, H05K 3/00, B29C 45/14, H01R 43/00

(30) Priority: **29.11.90 JP 334357/90**

(43) Date of publication of application:
**19.11.92 Bulletin 92/47**

(84) Designated Contracting States:
**AT BE CH DE DK ES FR GB GR IT LI LU NL SE**

(71) Applicant: **POLYPLASTICS CO. LTD.**
**3-13, Azuchicho, 2-chome**
**Chuo-Ku Osaka-shi Osaka 541(JP)**

(72) Inventor: **MIYASHITA, Takayuki 885-11,**
**Miyajima**
**Fuji-shi**
**Shizuoka 416(JP)**
Inventor: **AKETA, Tomoyuki 885-11, Miyajima**
**Fuji-shi**
**Shizuoka 416(JP)**

(74) Representative: **W.P. THOMPSON & CO.**
**Coopers Building, Church Street**
**Liverpool L1 3AN(GB)**

(54) **CUBIC MOLDED ARTICLE WITH BUILT-IN CUBIC CONDUCTOR CIRCUIT AND PRODUCTION METHOD THEREOF.**

(57) A cubic molded article with a built-in cubic conductor circuit can be obtained by molding a cubic circuit substrate bonded to a frame into a desired shape as primary molded article of a thermoplastic resin, applying a metallic conductor coating to the entire surface or necessary part of the primary molded article, fixing this primary molded article having the conductor coating on its surface to a mold for insert molding to form a secondary molded article which includes a sealed cubic conductor portion of the primary molded article and a frame portion exposed, and then cutting and removing the supporting frame. Large quantities of circuit components having a complicated cubic shape can be obtained.

Fig. 3

Industrial Applicability

The present invention relates to a synthetic resin-molded product incorporating three-dimensional conductive circuits in a sealed condition and also to a method of fabricating the molded product which is suitably applied to electric and electronic devices, such as connectors, IC packages and chassis incorporating printed circuit boards.

Prior Art

A common method of fabricating a resin-molded product having conductive circuits sealed therein consists of first working a metal to form conductive circuits connected to a fixed frame and insert-molding the worked metal (lead frame). In making complex three-dimensional circuits, this method requires a series of cutting and other forms of machining processes because the circuits to be inserted are made of a metal. This method therefore is very inefficient and economically not advantageous.

Methods of forming circuits on the surface of three-dimensional molds include an SKW method and a PCK method. In these methods, two materials with different metal-bonding performances are two-color molded to form a two-colored, molded product in which a part of the surface with a good metal-bonding performance that will form a conductive portion is distinguished by color from the, remaining part which does not bond to the metal and will form a non-conductive portion. Then the two-color molded product is subjected to treatments such as plating to form a metal layer over only that part of the resin surface corresponding to the conductive portion to produce a conductive circuit. With these methods, however, since a conductive metal film is formed on the composite product which was two-color molded beforehand, the fabrication of circuit is limited only to the surface of the molded product. Because the conductive portion is exposed on the surface, it is susceptible to damage due to wear. If the conductive portion is to be embedded in the mold, it is necessary to prepare a secondary mold which has through-holes for making a conductive circuit on the metal-adhesive resin portion and to bring the inner surface of the through-holes into contact with plating liquid to form the conductive metal film. This not only complicates the forming process but gives rise to another disadvantage that the through-holes formed in the mold are limited to simple, short, straight holes, making it impossible to contain the entire three-dimensional circuits of any complicated shape in the mold. Since there is a space remaining in the through-holes, the through-hole portions cannot be sealed completely. Further, since both of these methods perform treatments such as plating only after the two-color molding process, the plating liquid may enter the boundary between the two different materials and remain there for possible corrosion, or plating catalysts or liquid components may attach to the surface of the non-conductive part and enter into the interior thereof deteriorating the insulation of the mold.

Disclosure of the Invention

The inventors have conducted research and experiments to find a way of efficiently manufacturing a synthetic resin-molded product containing three-dimensional conductive circuits in a sealed condition and have arrived at this invention that overcomes the drawbacks of the conventional methods.

This invention is concerned with a method of making a molded product incorporating three-dimensional conductive circuits in a sealed condition and also with a three-dimensional molded product manufactured by this method. The method proposed by the invention consists of the following steps: first molding with a thermoplastic resin three-dimensional circuit patterns of a desired shape connected and secured to a fixing frame to form a primary molded product; coating the entire surface or a specified part of the surface of the primary molded product with a conductive metal to form a conductive portion on the surface; fixing to the die the primary molded product which was formed with the conductive portion on the surface; insert-molding the primary molded product with a secondary molding material to form a secondary molded product which buries and seals the three-dimensional conductive portion of the primary molded product, with the fixing frame portion exposed; and then cutting off the fixing frame.

Brief Description of the Drawings

Figure 1(a) is a perspective view of a primary molded product secured to a fixing frame which forms circuit patterns;
Figure 1(b) is a cross section taken along the line X-X of Figure 1(a);
Figure 2 is a cross section of the primary molded product (Figure 1) coated with a metal layer on its surface;
Figure 3(a) is a perspective view of a composite molded product made by further molding the metal-coated primary molded product in such a way as to bury the conductive portion under the second molding material;
Figure 3(b) is a cross section taken along the line X-X of Figure 3(a);
Figure 4 is a perspective view of a composite molded product (a final product) incorporating three-dimensional conductive circuits in a sealed condition with the frame removed; and

Figure 4(b) is a cross section taken along the line X-X of Figure 4(a).

1 Circuit patterns as the primary molded product

2 Fixing frame for the primary molded product

3 Metal film (conductive circuit)

4 Secondary molded portion

5 Terminals of the conductive circuits (plain terminals for solder connection)

5' Terminals of the conductive circuits (recessed terminals for receiving the mating terminals)

Now, the method of this invention will be described by referring to the attached drawings.

The primary molded product or circuit patterns are made of a thermoplastic resin that has a good metallic film bonding performance and is formed into a desired shape of circuit patterns 1, which are connected to a fixing frame 2. This circuit patterns are formed by injection molding. The primary molded product may consist of a large number of circuits integrally connected to one frame. The resin material used may be of any kind as long as it has a good metal-adhesiveness. But in terms of mass-productivity a thermoplastic resin is advantageous. It is also preferable to add the thermoplastic resin with various kinds of additives to enhance the resin's ability of bonding to metal that is coated over the primary product's surface in the next process. The additives may include inorganic fillers that give an anchor effect of increasing the metal-bonding ability as well as catalysts for plating.

It is also preferred that the resin material used have good mechanical properties, particularly high mechanical strength, and also high melting point and high rigidity so that it can retain the exact shape it is formed into and that it will not easily deform or break when subjected to heat and external force during the secondary molding process. The suitable resins that meet these requirements include such thermoplastic resins as liquid crystal polymers (for example, liquid crystal polyester), polyarylene sulfide, polyacetal, and polyalkylene terephthalate. The liquid crystal polyester and polyphenylene sulfide are particularly useful because they can be formed into a significantly fine or thin circuit pattern.

The primary molded product may be given surface treatment that is suited for the resin material to enhance its metal-bonding performance and thereby ensure that the metal film firmly attaches to the surface of the primary product in the next process. The surface treatments may include chemical etching using acid and alkaline liquids and physical surface treatments such as corona discharge or plasma treatment.

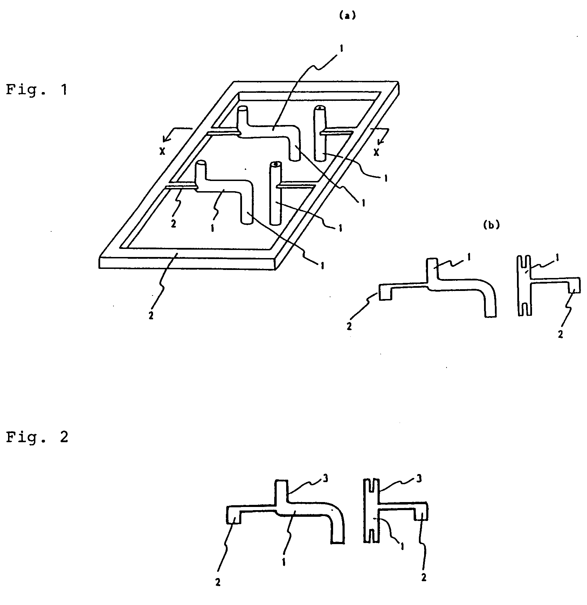

The primary molded product then undergoes a coating process where the entire surface of the primary product or at least parts of the surface that require conductivity (1 of Figure 1) are coated with a metal film or layer 3. The formation of the metal film 3 may be done by other known means than plating, such as sputtering, vacuum evaporation, ion plating, transfer, and painting of conductive agent. The most commonly used method is plating. The quality and thickness of the metal layer is determined according to the purpose of the product.

The primary molded product (Figure 2) coated with a conductive metal layer is then subjected to surface-cleaning and drying processes as required before proceeding to the secondary molding process.

In the secondary molding, the primary product is supported in place on the die by the frame 2, and then injection-molded (or insert-molded) with the secondary material so that the specified parts of the conductive portions 1, 3 are buried in a secondary molded product of a desired shape, with the terminals 5 and the frame 2 left exposed.

The secondary molding material is not limited to a particular one but any material may be used whose properties fit the use of the circuit component. Considering the ability of fusing with the primary product and bonding to the metal layer, the secondary molding material should preferably be of the same or similar kind of the primary molding material and also have a melting point almost equal to or lower than that of the primary product to prevent deformation of the conductive portions 1, 3 of the primary product. The melting point of the secondary molding material must not be significantly higher than that of the primary product. It is also desired that the secondary molding material have a good fluidity.

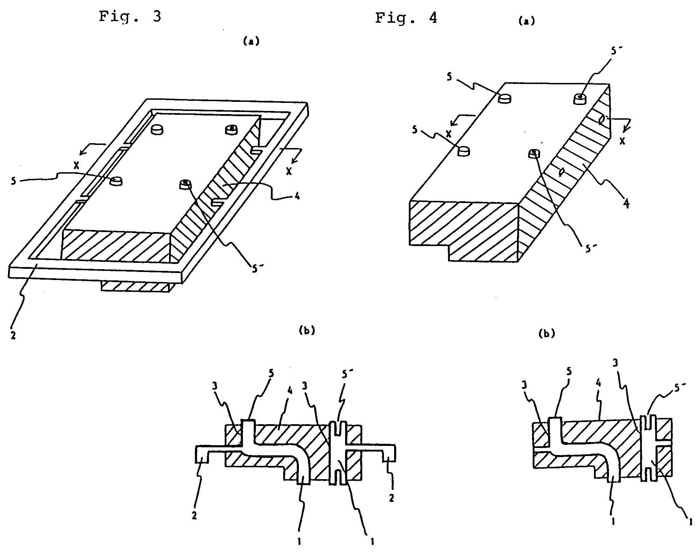

With the metal-coated conductive portions 1, 3 buried by the secondary molding, the secondary product (Figure 3) is cut and removed of the fixing frame 2 to form a final product of a desired shape (Figure 4) incorporating three-dimensional conductive circuits sealed therein.

In the final product, the exposed terminal 5 may either be formed to have a recessed portion like 5' into which the mating terminal is fitted, or formed into a plug that is fitted into the engagement recess of the mating terminal. The exposed terminal 5 may also be connected by solder. By connecting a large number of circuit patterns to a single frame, the primary molded product can have a large number of integrally molded independent circuits. When the circuit patterns to be formed are complex or when a large number of circuit patterns are formed close to each other, or when it is difficult to form the circuit patterns integral with a single frame, these circuit patterns may be connected to two or more frames and molded as multiple primary products, which in turn may be combined and supported on the secondary molding die and then molded into a final product containing these complex circuits.

The method of this invention and the molded product incorporating three-dimensional circuits fabricated according to this invention have the following advantages over the conventional method.

1. Since the circuit patterns *1* and the support frame *2* are integrally molded by injection molding, complex three-dimensional circuit patterns can be produced in large numbers, providing far better efficiency and economy than when the circuit patterns are formed by working the metal.

2. A product incorporating a large number of independent, complex, three-dimensional circuit patterns can be easily obtained.

3. As with the SKW method, the circuits are not exposed, so that they are protected against abrasion.

4. The SKW method requires that a clear distinction be made between the two materials of the two-color molded product in depositing a metal layer over one of them as by plating. Hence the SKW method needs delicate selection of plating conditions. The present invention, however, needs only to deposit a metal layer over the entire surface of the primary product, eliminating the plating condition selection process and thereby making the formation of metal layer very simple and easy.

5. With the SKW method, a conductive metal layer is formed as by plating over the selected portion of the two-color molded product, so that the plating liquid may enter the boundary between the two different materials for possible corrosion. With this invention, the metal layer is deposited over the primary molded product as by plating to form a conductive portion and, after being thoroughly cleaned and dried, is subjected to the secondary molding whereby the conductive portion is buried under the secondary molding material. Hence, there is no possibility of the plating liquid entering the boundary and corroding the product as experienced with the SKW method. Since the non-conductive portion is formed only after the metal layer is formed on the primary product, the plating liquid is prevented from polluting the mold or deteriorating the insulation resistance.

Embodiment

One embodiment of this invention will be described in detail by referring to the accompanying drawings. It is noted that the invention is not limited to this embodiment alone.

[Embodiment 1]

A resin composition with a good metal-bonding ability (plating ability) consisting mainly of liquid crystal polyester (trade name: "Vectra" made by Polyplastics K.K.) was injection-molded to form a primary product which has a plurality of circuit patterns connected to the frame (Figure 1). Next, the primary product was degreased and then etched over its almost entire surface by KOH aqueous solution. After this, it was neutralized by HCl aqueous solution, followed by washing with water. It was then surface-activated by a catalyst (trade name: "Catalyst A-30" made by Okuno Seiyaku Kogyo K.K.) and immersed in a chemical copper plating liquid comprising copper sulfate and assistant to copper-plate the surface of the primary product (Figure 2(b)). The plated primary product (Figure 2(b)) was thoroughly washed and dried, and then mounted to the secondary molding die and molded using a liquid crystal polyester to bury and seal the circuit portions (1 and 3) but leave the frame exposed. A secondary molded product of a desired shape was injection-molded (Figure 3). Then the exposed frame 2 protruding from the primary molded product was cut off to provide a final composite molded product which incorporates three-dimensional metal conductive circuits (Figure 4).

The composite product thus obtained contains and seals therein a large number of three-dimensional circuits (in this case only four circuits are shown combined, for simplicity) but is relatively small. This product is therefore suitably applied as an electric equipment component (such as connector).

**Claims**

1. A method of manufacturing a molded product incorporating three-dimensional conductive circuits in a sealed condition, comprising the steps of:

   molding a thermoplastic resin into three-dimensional circuit patterns of a desired shape connected and fixed to a frame as a primary molded product;

   coating a metal layer over the entire surface of the primary molded product or at least over a part of the surface that requires conductivity to form a conductive portion;

   fixing to a die the primary molded product, which has the conductive portion formed over the surface;

insert-molding the primary molded product with a secondary molding material to form a secondary molded product which buries and seals the three-dimensional conductive portion of the primary molded product with the frame left exposed; and

cutting and removing the fixing frame.

2. A method of manufacturing a molded product incorporating three-dimensional conductive circuits in a sealed condition as claimed in claim 1, wherein said metal layer on the primary molded product is formed by plating, sputtering, vacuum evaporation, ion plating, transfer, or painting of conductive agent.

3. A method of manufacturing a molded product incorporating three-dimensional conductive circuits in a sealed condition as claimed in claim 1, wherein said primary molding material for forming the three-dimensional circuit patterns is a thermoplastic resin or its composition that can bond to the metal layer.

4. A method of manufacturing a molded product incorporating three-dimensional conductive circuits in a sealed condition as claimed in claim 1, wherein said secondary molding material is a thermoplastic resin or its composition.

5. A molded product incorporating three-dimensional conductive circuits in a sealed condition, which is formed according to the method of claim 1.

(a)

Fig. 1

(b)

Fig. 2

Fig. 3

(a)

Fig. 4

(a)

(b)

(b)

# INTERNATIONAL SEARCH REPORT

International Application No  PCT/JP91/01644

**I. CLASSIFICATION OF SUBJECT MATTER** (if several classification symbols apply, indicate all) 6

According to International Patent Classification (IPC) or to both National Classification and IPC

Int. Cl$^5$  H05K3/40, 3/20, 3/00, B29C45/14, H01R43/00

**II. FIELDS SEARCHED**

| Minimum Documentation Searched 7 | |
|---|---|
| Classification System | Classification Symbols |
| IPC | H05K3/40, 3/20, 3/00, H01R43/00, B29C45/14 |

Documentation Searched other than Minimum Documentation
to the Extent that such Documents are Included in the Fields Searched 8

Jitsuyo Shinan Koho                  1926 - 1991
Kokai Jitsuyo Shinan Koho            1971 - 1991

**III. DOCUMENTS CONSIDERED TO BE RELEVANT** 9

| Category * | Citation of Document, 11 with indication, where appropriate, of the relevant passages 12 | Relevant to Claim No. 13 |
|---|---|---|
| Y | JP, A, 62-179792 (NEC Corp.), August 6, 1987 (06. 08. 87), (Family: none) | 1-3 |
| Y | JP, A, 58-18215 (Sato Giko K.K.), February 2, 1983 (02. 02. 83), (Family: none) | 1-3 |

* Special categories of cited documents: 10

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

**IV. CERTIFICATION**

| Date of the Actual Completion of the International Search | Date of Mailing of this International Search Report |
|---|---|
| February 4, 1992 (04. 02. 92) | February 25, 1992 (25. 02. 92 |
| International Searching Authority | Signature of Authorized Officer |
| Japanese Patent Office | |

Form PCT ISA/210 (second sheet) (January 1985)